# EUROPEAN PATENT APPLICATION

(11) **EP 4 648 278 A1**
(43) Date of publication of application: **12.11.2025**
(21) Application number: 23914884.4
(22) Date of filing: 12.07.2023
(51) Int. Cl.: H02S 40/22, H02S 20/30, H01L 31/0475, H01L 31/02, H01L 31/0352

(54) **HIGH EFFICIENCY PHOTOVOLTAIC POWER GENERATION SYSTEM**

(30) Priority: 06.01.2023 KR 20230002164
(71) Applicant: SOFTPV Inc., Hwaseong-si, Gyeonggi-do 13215 (KR)
(72) Inventor: LEE, Sung Gue, Hwaseong-si, Gyeonggi-do 18497 (KR); AHN, Hyeon Woo, Seongnam-si, Gyeonggi-do 13646 (KR)
(74) Representative: Petraz, Gilberto Luigi
(86) International application number: PCT/KR2023/009906
(87) International publication number: WO 2024/147419

(57) **Abstract**

A photovoltaic power generation system is disclosed. The photovoltaic power generation system according to the present disclosure is configured such that photovoltaic power generators that allow sunlight to pass therethrough are arranged in a stacked form in a specific space, unlike conventional systems, thereby maximizing energy production efficiency.

## Description

### Technical Field

The present disclosure relates to a photovoltaic power generation system.

More particularly, the present disclosure relates to a photovoltaic power generation system configured to maximize energy production efficiency by enabling sunlight, which travels in a direction in a specific space, to pass through a photovoltaic power generator multiple times.

### Background Art

Photovoltaic power generation uses sunlight to produce energy, and has been attracting attention as a renewable energy source due to growing interest in environmental issues. Accordingly, each country is attempting to convert existing energy production systems to eco-friendly energy systems.

Recently, reflecting such circumstances, the adoption of photovoltaic power generation at the level of apartment buildings has been actively carried out, and photovoltaic systems applicable to various locations such as roofs, outer walls, canopies, and balconies have been developed.

However, photovoltaic power generation systems have unresolved problems in that, first, a large area is required, and second, exposure to the outside is necessary.

Photovoltaic power generation has lower efficiency compared to conventional energy production methods. Accordingly, in order to produce usable energy, a large number of cells are needed, and the cells are required to be arranged in parallel over a wide area. Therefore, photovoltaic power generation systems are installed in regions other than cities with high population density.

In addition, since photovoltaic power generation requires exposure to light, the cells are required to be exposed to the outside facing the sky. Therefore, significant restrictions arise in the installation of photovoltaic power generation systems. To overcome the foregoing, a method of reflecting light into the interior of a building using a reflector or the like has been devised. However, because the interior of a building has limited area, only a small amount of energy can be produced due to the limited area. Therefore, photovoltaic power generation systems have limitations in practical implementation.

### DISCLOSURE

### Technical Problem

An embodiment of the present disclosure is to provide a photovoltaic power generation system that overcomes the above-described problems.

An embodiment of the present disclosure is to provide a photovoltaic power generation system having high applicability by generating a large amount of energy even in a narrow area.

An embodiment of the present disclosure is to provide a photovoltaic power generation system having high applicability by generating a large amount of energy even when located indoors.

### Technical Solution

A photovoltaic power generation system according to an embodiment of the present disclosure may include a flow path component along which sunlight travels, and a plurality of photovoltaic power generators configured not to block at least the sunlight, and arranged in a direction in which the sunlight is transmitted.

The plurality of photovoltaic power generators may be arranged along a direction in which the sunlight travels.

The flow path component may include a reflective surface capable of reflecting light, so that sunlight that passes through any one of the photovoltaic power generators is reflected by the reflective surface and passes through the corresponding photovoltaic power generator again.

The photovoltaic power generators may be detachably located in the flow path component.

Each of the photovoltaic power generators may include a transmissive film layer a transmissive film layer having at least a peripheral surface that is not flexible, and
a cell located on one surface of the transmissive film layer and configured to receive the sunlight and generate energy, the cell being not disposed in a form that at least blocks an entire surface of the transmissive film layer.

The transmissive film layer may include a frame portion defining an internal space, and a film portion located in the frame portion, the film portion including a circuit diagram printed thereon and being configured at least not to block transmission of the sunlight.

The flow path component may include a plurality of mounting portions that are spaces spaced apart from each other, and the photovoltaic power generators may be respectively detachably installed in the mounting portions.

The photovoltaic power generation system may include an electrolysis component configured to generate energy by electrolyzing water.

The photovoltaic power generators may be located on one surface of the electrolysis component, and may be operated as a power supply to apply a negative electrode and a positive electrode to the electrolysis component.

### Advantageous Effects

According to an embodiment of the present disclosure, a photovoltaic power generator capable of transmitting sunlight is located along a flow path of a flow path component capable of reflecting sunlight, thereby producing a large amount of energy relative to space during energy production.

Therefore, the present disclosure can be applied to various locations such as the interior of a building or a vehicle, and thus has very high applicability.

### Brief Description of Drawings

FIG. 1 illustrates a photovoltaic power generator in a photovoltaic power generation system according to an embodiment of the present disclosure.
FIG. 2 is a sectional view of the photovoltaic power generation system according to an embodiment of the present disclosure.
FIG. 3 is a sectional view of a photovoltaic power generation system according to another embodiment of the present disclosure.
FIG. 4 is a sectional view of a photovoltaic power generation system according to still another embodiment of the present disclosure.
FIG. 5 is a sectional view of a photovoltaic power generation system according to yet another embodiment of the present disclosure.
FIG. 6 illustrates a first embodiment of a photovoltaic power generator of the photovoltaic power generation system according to the embodiment of FIG. 5.
FIG. 7 illustrates a second embodiment of a photovoltaic power generator of the photovoltaic power generation system according to the embodiment of FIG. 5.
FIG. 8 is an enlarged view of an electrolysis component among components of the photovoltaic power generation system according to an embodiment.
FIG. 9 is a schematic diagram illustrating a photovoltaic power generation system according to an embodiment of the present disclosure.
FIG. 10 is a sectional view of a photovoltaic power generation system according to still another embodiment of the present disclosure.

### Best Mode

Hereinbelow, an embodiment of the present disclosure will be described in detail with reference to exemplary drawings. However, this is not intended to limit the scope of the present disclosure.

In adding reference numerals to elements in each drawing, it should be noted that the same components are designated by the same reference numerals, if possible, although they are shown in different drawings. Furthermore, in the following description, a detailed explanation of known related configuration or function may be omitted to avoid unnecessarily obscuring the subject matter of the present disclosure.

Also, the size, shape, etc. of the components shown in the drawings may be exaggerated for clarity and convenience of description. Furthermore, terms specifically defined in consideration of the configuration and operation of the present disclosure are only for describing the embodiments of the present disclosure and do not limit the scope of the present disclosure.

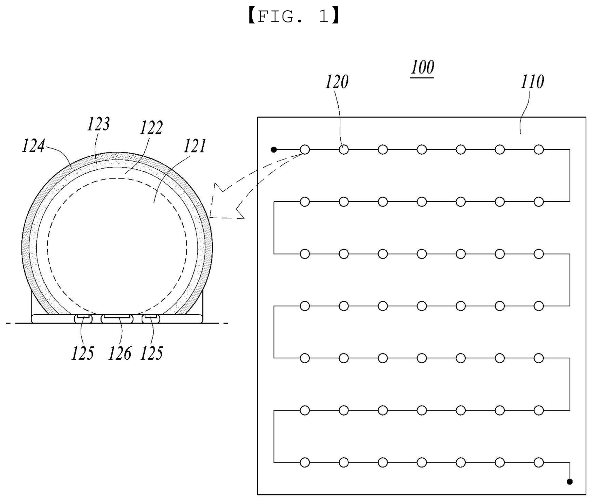

FIG. 1 illustrates a photovoltaic power generator in a photovoltaic power generation system according to an embodiment of the present disclosure.

According to the present disclosure, the photovoltaic power generator 100 is formed in a shape in which cells 120 are arranged on a transmissive film layer 110, as illustrated in FIG. 1. Here, each of the cells 120 may be in the form of a spherical particle 120, which is visually indiscernible, as shown in FIG. 1. Accordingly, sunlight irradiated toward the photovoltaic power generator 100 may pass through the transmissive film layer 110. Therefore, even when the photovoltaic power generator 100 has a stacked structure, photovoltaic power generation may be performed.

The photovoltaic power generator 100 according to an embodiment of the present disclosure may include the transmissive film layer 110 and the particles 120.

The transmissive film layer 110 may be formed of a flexible material, and may be formed in a specific shape. For example, the transmissive film layer 110 may be formed in a rectangular plate shape. The transmissive film layer 110 may be transparent or opaque. However, it is desirable that the transmissive film layer 110 be formed of a material or substance that allows sunlight to pass through.

A circuit diagram may be printed on the transmissive film layer 110. The circuit diagram may be printed on one surface of the transmissive film layer 110 and may be connected in series or in parallel. FIG. 1 illustrates an example of a series circuit diagram shown on a film portion 111.

Each particle 120 may include a first electrode layer 121, a second electrode layer 122, a passivation layer 123, a blocking layer 124, a first connector 125, and a second connector 126.

The particle 120 is formed in a spherical shape with a lower portion exposed. That is, the particle 120 may be formed in a spherical shape by connecting other components to each other. The first electrode layer 121 and the second electrode layer 122 may be arranged in a form in which the second electrode layer 122 is located out the first electrode layer 121. The first electrode layer 121 and the second electrode layer 122 may be formed in a shape in which lower portions thereof are cut in a horizontal direction. In addition, the first electrode layer 121 and the second electrode layer 122 may be arranged in a form in which the second electrode layer 122 is located in the first electrode layer 121. The first electrode layer 121 and the second electrode layer 122 may include silicon of different types.

For example, the first electrode layer 121 may be N-type silicon, and the second electrode layer 122 may be P-type silicon. Therefore, when sunlight reaches the particle 120, energy may be generated by movement of electrons and holes.

In the case where the first electrode layer 121 is N-type silicon and the second electrode layer 122 is P-type silicon, electrons and holes may be respectively collected at the first connector 125 connected to a lower portion of the first electrode layer 121 and the second connector 126 disposed under the second electrode layer 122, and as a result, electric current may flow through a circuit diagram of the transmissive film layer 110.

The passivation layer 123 may be located outside the first electrode layer 121 to allow smooth transfer of electrons and holes. The blocking layer 124 may be disposed in a shape that encloses the passivation layer 123, thereby preventing reflection of sunlight.

As described above, the present disclosure enables the particles 120, which are visually indiscernible, to generate energy. Although each particle 120 may generate a minute amount of energy (electrical energy), when the energy generated by the particles 120 is combined, a significantly larger amount of power (electrical energy) may be produced compared to existing solar cells 120.

In addition, because the circuit diagram is printed on the transmissive film layer 110 and the particles 120 are arranged on an upper side of the circuit diagram, the circuit diagram may be formed in various patterns, and the spacing between the particles 120 may also be adjusted.

In addition, the first connector 125 and the second connector 126 may be located in the particle 120. The first connector 125 may be connected to the first electrode layer 121, and the second connector 126 may be connected to the second electrode layer 122. Here, the first connector 125 may be a positive (+) electrode or a negative (-) electrode depending on the types of the first electrode layer 121 and the second electrode layer 122, and the second connector 126 may be an electrode opposite thereto.

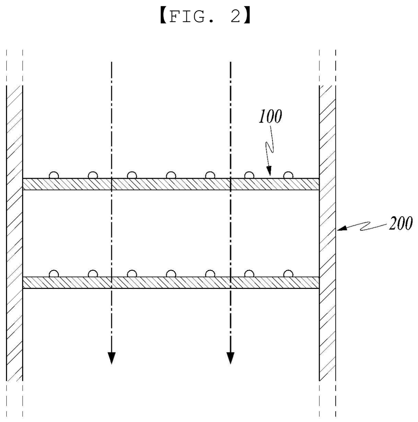

FIG. 2 is a sectional view of the photovoltaic power generation system according to an embodiment of the present disclosure.

The photovoltaic power generation system according to an embodiment of the present disclosure may include a flow path component 200 and the photovoltaic power generator 100.

As described above, the photovoltaic power generator 100 according to the present disclosure may generate energy using sunlight. In addition, the photovoltaic power generator 100 according to the present disclosure allows sunlight to pass therethrough. Accordingly, if a plurality of photovoltaic power generators 100 are arranged along a path through which sunlight travels, energy utilization relative to space may be increased. In the present disclosure, a plurality of photovoltaic power generators 100 are arranged along the flow path component 200 through which sunlight travels. Therefore, the present disclosure may provide markedly high efficiency in energy production.

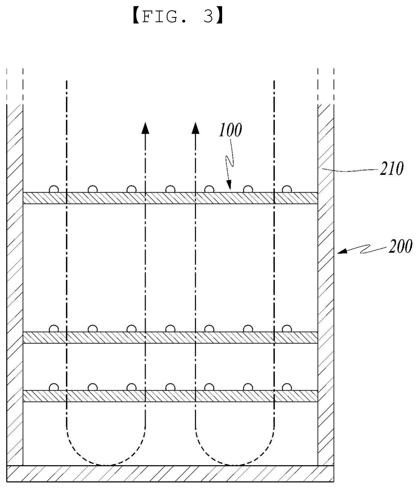

FIG. 3 is a sectional view of a photovoltaic power generation system according to another embodiment of the present disclosure.

The photovoltaic power generation system according to another embodiment of the present disclosure may be characterized in that a reflective surface 210 is formed in the flow path component 200. That is, sunlight may be reflected by the reflective surface 210 while traveling along the flow path component 200. For example, based on FIG. 3, sunlight may travel downward and then be reflected to travel upward. Accordingly, sunlight that passes through any one photovoltaic power generator 100 may be reflected and may travel again through the photovoltaic power generator 100 through which the sunlight has passed.

Accordingly, sunlight may travel multiple times along the flow path component 200 and may pass multiple times through the photovoltaic power generator 100. Therefore, the photovoltaic power generator 100 may generate a large amount of energy. Although FIG. 3 illustrates, for convenience of explanation, that the cells 120 are positioned only on an upper surface of the transmissive film layer 110, the present disclosure is not limited thereto, and the cells 120 may also be arranged on both surfaces.

Furthermore, the flow path component 200 may have various shapes in addition to a linear shape. The reflective surface 210 may be formed on the entirety of an inner surface of the flow path component 200, or may be formed only on a portion thereof to reflect sunlight.

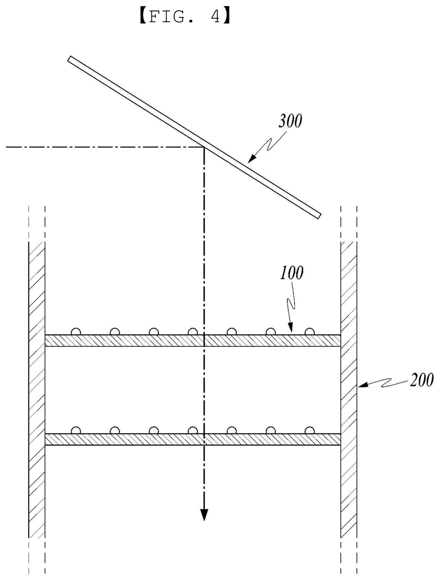

FIG. 4 is a sectional view of a photovoltaic power generation system according to still another embodiment of the present disclosure.

The photovoltaic power generation system according to still another embodiment of the present disclosure may further include a light collector 300. The light collector 300 may reflect sunlight or concentrate sunlight toward a single focal point. In addition, the light collector 300 may reflect sunlight so that the sunlight passes through and travels along the flow path component 200.

For example, as illustrated in FIG. 4, the light collector 300 may be located at an entrance side of the flow path component 200 and may reflect sunlight to allow the sunlight to travel into the flow path component 200. Therefore, the flow path component 200 is not limited in position and may be located at a specific position by the light collector 300.

The light collector 300 only needs to function as a guide that collects or reflects sunlight, and the shape thereof may not be a critical factor.

Although not illustrated in FIG. 4, it is apparent that the reflective surface 210 shown in FIG. 3 may be formed in the flow path component 200.

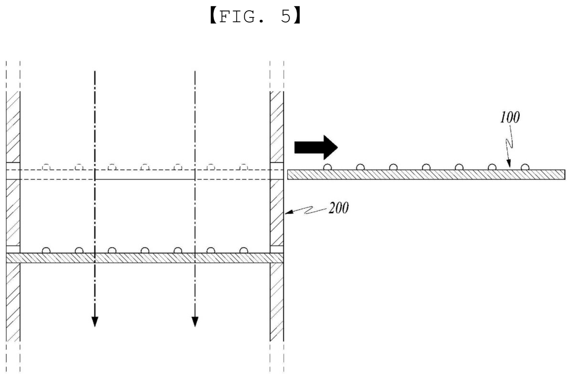

FIG. 5 is a sectional view of a photovoltaic power generation system according to yet another embodiment of the present disclosure.

The photovoltaic power generator 100 according to yet another embodiment of the present disclosure may be detachably located in the flow path component 200. A mounting portion may be formed in the flow path component 200. For example, the mounting portion may be a gap formed in the flow path component 200. It should be noted that the gap illustrated in FIG. 5 is shown in an exaggerated manner.

The gap may be formed in the flow path component 200. Here, a plurality of gaps may be formed. Each photovoltaic power generator 100 may slide to pass through the corresponding gap and may be secured to the flow path component 200. That is, as illustrated in FIG. 5, the photovoltaic power generator 100 may slide from the left to the right and may be positioned in the flow path component 200. In contrast, the photovoltaic power generator 100 positioned in the flow path component 200 may be slid and removed from the flow path component 200.

Here, the plurality of gaps of the flow path component 200 may be arranged along a path through which sunlight travels. Therefore, a user may place the photovoltaic power generators 100 in the flow path component 200 or remove the photovoltaic power generators 100 from the flow path component 200 as needed. Accordingly, the user may control the number of photovoltaic power generators 100 or easily replace a damaged photovoltaic power generator 100 with another one.

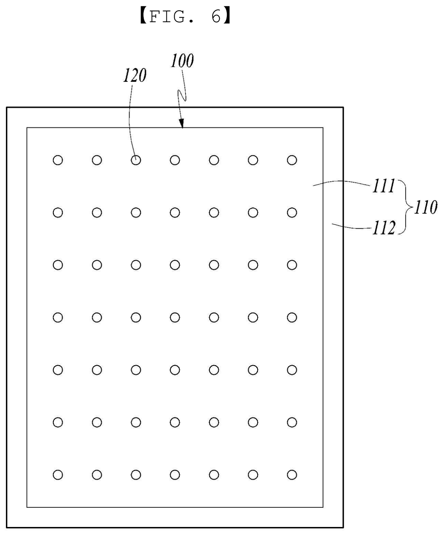

FIG. 6 illustrates a first embodiment of the photovoltaic power generator of the photovoltaic power generation system according to the embodiment of FIG. 5.

The transmissive film layer 110 of the photovoltaic power generator 100 may include a frame portion 112 and a film portion 111.

As illustrated in FIG. 6, the frame portion 112 may form a peripheral surface, and the film portion 111 may be located inside the frame portion 112. A circuit diagram may be drawn on the film portion 111 (not shown in FIG. 6), and the cells 120 may be located on one surface or a remaining surface thereof. The frame portion 112 may be formed in a shape corresponding to the shape of the film portion 111.

For example, in the case where the film portion 111 is formed in a rectangular shape, the frame portion 112 may also be formed in a rectangular shape. The frame portion 112 may provide rigidity to the flexible transmissive film layer 110.

Therefore, a worker may install or remove the photovoltaic power generator 100 including the frame portion 112 in or from the flow path component 200 by sliding, as illustrated in FIG. 5, the photovoltaic power generator 100 into or from the flow path component 200.

Here, the shape of the frame portion 112 is not limited as long as a space can be formed inside the frame portion 112 to allow the transmissive film layer 110 to be positioned therein. For example, although not illustrated, the frame portion 112 may be formed in a circular shape without causing any problem.

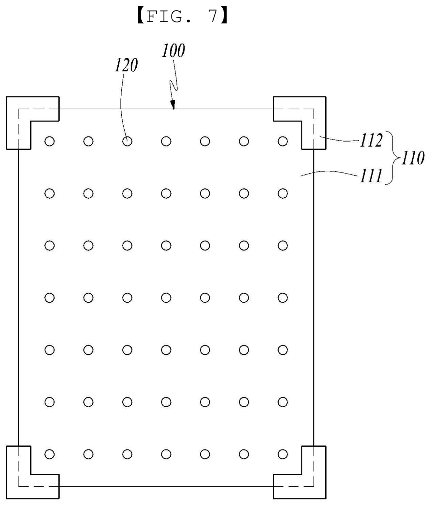

FIG. 7 illustrates a second embodiment of the photovoltaic power generator of the photovoltaic power generation system according to the embodiment of FIG. 5.

In the case of the second embodiment, the shape of the frame portion 112 of the transmissive film layer 110 may not be limited as long as the frame portion 112 is formed in a shape enclosing corners of the film portion 111. For example, as illustrated in FIG. 7, the frame portion 112 may be formed in an "L" shape and may enclose each corner of the film portion 111. That is, the frame portion 112 may be formed in a shape that encloses only a partial region of the film portion 111.

However, the photovoltaic power generator 100 may be positioned in the flow path component 200 merely by the frame portion 112 being placed in the mounting portion of the flow path component 200.

For example, assuming that the present disclosure is applied to a building, the light collector 300 as illustrated in FIG. 4 may be positioned on a rooftop of the building, and a floor below the rooftop may function as the flow path component 200. Here, the flow path component 200 may correspond to a space in the building, and the mounting portion may be a gap formed in a column or a wall of the building. The user may install the photovoltaic power generator 100 according to the present disclosure in the flow path component 200 by positioning the frame portion 112 in the mounting portion in a sliding manner.

In the second embodiment of FIG. 7, the shape of the frame portion 112 may not be limited as long as the frame portion 112 encloses only a part of the film portion 111 and the film portion 111 is able to receive sunlight when the frame portion 112 is installed in the mounting portion in a sliding manner.

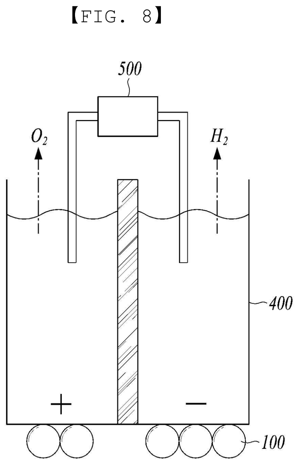

FIG. 8 is an enlarged view of an electrolysis component among the components of the photovoltaic power generation system according to an embodiment.

The photovoltaic power generation system according to an embodiment may further include an electrolysis component 400.

The electrolysis component 400 may generate energy by electrolyzing water using energy produced by the photovoltaic power generation system described above. The generated energy may be supplied to an energy consumption component 500. In the electrolysis component 400, water mixed with an electrolyte may be positioned in a designated space.

That is, the electrolysis component 400 may electrolyze water using energy, so that energy generated by the electrolysis component 400 may be supplied to the energy consumption component 500 (e.g., a device such as motor, or a similar type of device that produces usable power by using energy) .

It should be noted that energy produced by the above-mentioned photovoltaic power generation system may be supplied to the energy consumption component 500.

A plurality of photovoltaic power generators 100 may be located on one surface of the electrolysis component 400 according to the present disclosure. Each photovoltaic power generator 100 may have a basic structure as illustrated in FIG. 1. That is, the photovoltaic power generator 100 may include cells 120 (i.e., particles 120) each including a first electrode layer 121 and a second electrode layer 122.

Here, the first electrode layer 121 and the second electrode layer 122 may be similar to those described in FIG. 1, and the first connector 125 and the second connector 126 may be respectively located at different positions in the electrolysis component 400. Therefore, a positive (+) electrode and a negative (-) electrode may be applied to the electrolysis component 400, respectively.

Alternatively, the first electrode layer 121 and the second electrode layer 122 may be changed. That is, the connectors connected to the electrolysis component 400 may be the same, but the first electrode layer 121 of any one of the cells 120 may be N-type silicon, while the first electrode layer 121 of another cell 120 may be P-type silicon. Of course, the second electrode layer 122 located outside each of the foregoing first electrode layers 121 may be silicon of a type opposite to that of the corresponding first electrode layer 121.

Therefore, in the case where sunlight is applied to the photovoltaic power generator 100 located on the electrolysis component 400, the positive (+) electrode and the negative (-) electrode may be applied to the electrolysis component 400, thereby allowing electrolysis to occur and enabling energy to be produced. The energy produced in the aforementioned way may be supplied to the energy consumption component 500.

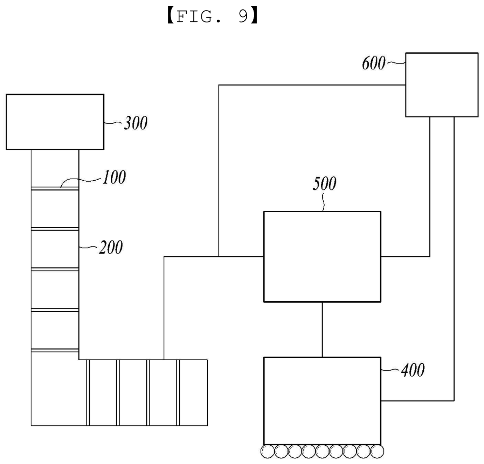

FIG. 9 is a schematic diagram illustrating a photovoltaic power generation system according to an embodiment of the present disclosure.

A photovoltaic power generation system according to an embodiment of the present disclosure may include a photovoltaic power generator 100, a flow path component 200, a light collector 300, an electrolysis component 400, an energy consumption component 500, and a storage component 600.

The photovoltaic power generator 100, the flow path component 200, the light collector 300, and the electrolysis component 400 are as described above.

In the present disclosure, energy generated by the photovoltaic power generator 100 or energy generated by the electrolysis component 400 may be directly supplied to the energy consumption component 500. Therefore, the energy consumption component 500 may consume the energy. Here, surplus energy may be supplied to and stored in the storage component 600 (e.g., a battery).

As described above, the present disclosure may be applied to various fields. The present disclosure may be installed in any place, regardless of space or location, as long as there is space where the flow path component 200 and the photovoltaic power generator 100 can be located, including, for example, ultra-large buildings, ultra-small buildings, livestock sheds, farms, specific regions, and vehicles using electricity, and may generate high-efficiency energy.

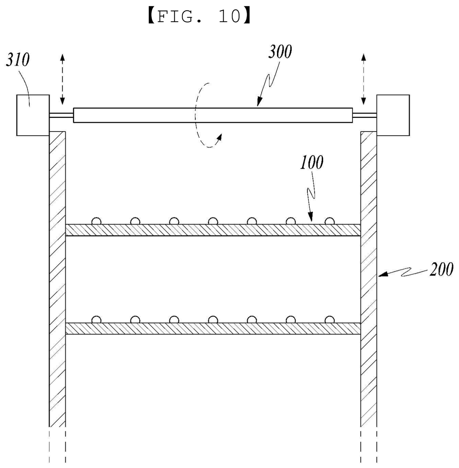

FIG. 10 is a sectional view of a photovoltaic power generation system according to still another embodiment of the present disclosure.

The photovoltaic power generation system according to still another embodiment of the present disclosure may further include a moving component 310. The moving component 310 may be movably located on the flow path component 200 and may move the light collector 300. The moving component 310 may be rotatable with the flow path component 200 as an axis. In addition, the moving component 310 may tilt or rotate the light collector 300.

In other words, the moving component 310 may itself be movable and may move the light collector 300 connected thereto. Accordingly, the position and tilting angle of the light collector 300 may be changed by the moving component 310.

Here, energy for operating the moving component 310 may be obtained from energy generated by the photovoltaic power generator 100. That is, the moving component 310 may use a portion of high-efficiency energy generated by the photovoltaic power generator 100 due to the light collector 300 to move the light collector 300, thereby enabling more efficient energy generation. Although specific embodiments of the present disclosure have been described for illustrative purposes, those skilled in the art will appreciate that various modifications, additions and substitutions are possible, without departing from the technical spirit of the disclosure as disclosed in the accompanying claims.

### [Description of Reference Numerals]

100: Photovoltaic power generator
110: Transmissive film layer
111: Film portion
112: Frame portion
120: Cell or Particle
121: First electrode layer
122: Second electrode layer
123: Passivation layer
124: Blocking layer
125: First connector
126: Second connector
200: Flow path component
210: Reflective surface
300: Light collector
310: Moving component
400: Electrolysis component
500: Energy consumption component
600: Storage component

## Claims

1. A photovoltaic power generation system comprising:
a flow path component along which sunlight travels; and
a plurality of photovoltaic power generators configured not to block at least the sunlight, and arranged in a direction in which the sunlight is transmitted.

2. The photovoltaic power generation system according to claim 1, wherein the plurality of photovoltaic power generators are arranged along a direction in which the sunlight travels.

3. The photovoltaic power generation system according to claim 2, wherein the flow path component includes a reflective surface capable of reflecting light, so that sunlight that passes through any one of the photovoltaic power generators is reflected by the reflective surface and passes through the corresponding photovoltaic power generator again.

4. The photovoltaic power generation system according to claim 1, wherein the photovoltaic power generators are detachably located in the flow path component.

5. The photovoltaic power generation system according to claim 4, wherein each of the photovoltaic power generators comprises
a transmissive film layer having at least a peripheral surface that is not flexible, and
a cell located on one surface of the transmissive film layer and configured to receive the sunlight and generate energy, the cell being not disposed in a form that at least blocks an entire surface of the transmissive film layer.

6. The photovoltaic power generation system according to claim 5, wherein the transmissive film layer includes a frame portion defining an internal space, and a film portion located in the frame portion, the film portion including a circuit diagram printed thereon and being configured at least not to block transmission of the sunlight.

7. The photovoltaic power generation system according to claim 5,
wherein the flow path component includes a plurality of mounting portions that are spaces spaced apart from each other, and
wherein the photovoltaic power generators are respectively detachably installed in the mounting portions.

8. The photovoltaic power generation system according to claim 1, wherein the photovoltaic power generation system comprises an electrolysis component configured to generate energy by electrolyzing water.

9. The photovoltaic power generation system according to claim 8, wherein the photovoltaic power generators are located on one surface of the electrolysis component, and are operated as a power supply to apply a negative electrode and a positive electrode to the electrolysis component.

10. The photovoltaic power generation system according to claim 2, wherein a light collector is located on one side of the flow path component and is configured to collect the sunlight.

11. The photovoltaic power generation system according to claim 10, wherein the light collector is coupled to a moving component configured to change a position of the light collector.

12. The photovoltaic power generation system according to claim 11,
wherein the moving component is configured to rotate with a center of the flow path component as an axis, and to tilt or rotate the light collector.
